(19) Europäisches Patentamt / European Patent Office / Office européen des brevets

(11) **EP 3 914 558 B1**

(12) **EUROPEAN PATENT SPECIFICATION**

(45) Date of publication and mention
of the grant of the patent:
**27.08.2025 Bulletin 2025/35**

(51) International Patent Classification (IPC):
$C01G\ 29/00^{(2006.01)}$    $C04B\ 35/475^{(2006.01)}$
$C04B\ 35/465^{(2006.01)}$    $C04B\ 35/468^{(2006.01)}$
$C04B\ 35/49^{(2006.01)}$    $C04B\ 35/495^{(2006.01)}$
$C04B\ 35/626^{(2006.01)}$

(21) Application number: **20703804.3**

(22) Date of filing: **27.01.2020**

(52) Cooperative Patent Classification (CPC):
**C01G 29/006; C04B 35/465; C04B 35/4682;
C04B 35/475; C04B 35/49; C04B 35/495;
C04B 35/62655; H10N 30/8542;** C01P 2002/72;
C01P 2004/03; C04B 2235/3201; C04B 2235/3203;
C04B 2235/3213; C04B 2235/3298;
C04B 2235/768; (Cont.)

(86) International application number:
**PCT/GB2020/050177**

(87) International publication number:
**WO 2020/152483 (30.07.2020 Gazette 2020/31)**

(54) **PROCESS FOR THE PREPARATION OF BISMUTH SODIUM TITANATE**

VERFAHREN ZUR HERSTELLUNG VON WISMUT-NATRIUM-TITANAT

PROCÉDÉ DE PRÉPARATION DE TITANATE DE BISMUTH DE SODIUM

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.01.2019 GB 201901069**

(43) Date of publication of application:
**01.12.2021 Bulletin 2021/48**

(73) Proprietor: **Ceramic Powder Technology AS
7093 Tiller (NO)**

(72) Inventors:
• **EINARSRUD, Mari-Ann**
  **7027 Trondheim (NO)**
• **HEINTZ, Mads**
  **4623 Kristiansand (NO)**
• **LABONNOTE-WEBER, Sophie Beatrice**
  **7026 Trondheim (NO)**
• **SYVERTSEN-WIIG, Guttorm**
  **7022 Trondheim (NO)**
• **GRANDE, Tor**
  **7050 Trondheim (NO)**
• **JØSANG, Leif Olav**
  **7068 Trondheim (NO)**

(74) Representative: **Dehns
10 Old Bailey
London EC4M 7NG (GB)**

(56) References cited:
• **JUNG D S ET AL: "Fine-sized Bi0.5Na0.5TiO3
  powders prepared by spray pyrolysis from
  polymeric precursors", JOURNAL OF CERAMIC
  PROCESSING RESEARCH, INTERNATIONAL
  ORGANIZATION FOR CERAMIC PROCESSING,
  SEOUL, KR, vol. 11, no. 4, 1 January 2010
  (2010-01-01), pages 425 - 431, XP009520010,
  ISSN: 1229-9162**
• **C. SANGSUBUN: "Fabrication and
  characterization of bismuth sodium titanate
  ceramics by high-energy ball milling technique",
  CERAMICS INTERNATIONAL., vol. 41, 1 July
  2015 (2015-07-01), NL, pages S180 - S184,
  XP055687568, ISSN: 0272-8842, DOI: 10.1016/
  j.ceramint.2015.03.123**

- QU Y ET AL: "Effect of A-site substitution on crystal component and dielectric properties in Bi"0"."5Na"0"."5TiO"3 ceramics", MATERIALS SCIENCE AND ENGINEERING: B, ELSEVIER, AMSTERDAM, NL, vol. 121, no. 1-2, 25 July 2005 (2005-07-25), pages 148 - 151, XP027791956, ISSN: 0921-5107, [retrieved on 20050725]
- XIAO D Q ET AL: "Investigation on the design and synthesis of new systems of BNT-based lead-free piezoelectric ceramics", JOURNAL OF ELECTROCERAMICS, KLUWER ACADEMIC PUBLISHERS, BO, vol. 16, no. 4, 1 July 2006 (2006-07-01), pages 271 - 275, XP019450578, ISSN: 1573-8663, DOI: 10.1007/S10832-006-9863-7
- ZHOU C ET AL: "Microstructure and electrical properties of Bi"0"."5Na"0"."5TiO"3-Bi"0"."5K"0"."5TiO"3-LiNbO"3 lead-free piezoelectric ceramics", JOURNAL OF PHYSICS AND CHEMISTRY OF SOLIDS, PERGAMON PRESS, LONDON, GB, vol. 70, no. 3-4, 1 March 2009 (2009-03-01), pages 541 - 545, XP026101794, ISSN: 0022-3697, [retrieved on 20081216], DOI: 10.1016/J.JPCS.2008.12.013
- CHEN X ET AL: "Microstructure, dielectric and ferroelectric properties of (1-x)(0.94Bi"0"."5Na"0"."5TiO"3-0.06BaTiO"3)-xBi-FeO"3 lead-free ceramics synthesized via a high energy ball milling method", JOURNAL OF ALLOYS AND COMPOUNDS, ELSEVIER SEQUOIA, LAUSANNE, CH, vol. 507, no. 2, 8 October 2010 (2010-10-08), pages 535 - 541, XP027320522, ISSN: 0925-8388, [retrieved on 20100812]
- HUSSAIN A ET AL: "Effects of Hafnium Substitution on Dielectric and Electromechanical Properties of Lead-free Bi0.5(Na0.78K0.22)0.5(Ti1-xHfx)O3 Ceramics", JAPANESE JOURNAL OF APPLIED PHYSICS, JAPAN SOCIETY OF APPLIED PHYSICS, JP, vol. 49, no. 4, 1 April 2010 (2010-04-01), pages 41504 - 1, XP001553994, ISSN: 0021-4922, [retrieved on 20100420], DOI: 10.1143/JJAP.49.041504

(52) Cooperative Patent Classification (CPC): (Cont.)
C04B 2235/80; Y02E 60/10

**Description**

<u>Field</u>

The present invention relates to a new process for the manufacture of bismuth sodium titanate (BNT) based materials.

<u>Background</u>

Ferroelectric materials have many important applications as functional materials in electronics and optics. A large number of ferroelectric ceramics exploit properties that are an indirect consequence of ferroelectricity, such as dielectric, piezoelectric, pyroelectric and electro-optic properties. With the development of ceramic processing and thin film technology, many new applications have emerged. The biggest uses of ferroelectric ceramics have been in areas such as dielectric ceramics for capacitor applications, ferroelectric thin films for non-volatile memories, piezoelectric materials for medical ultrasound imaging and actuators, and electro-optic materials for data storage and displays.

The most commonly used piezoelectric material, lead zirconate titanate (PZT), has the chemical formula $PbZr_xTi_{1-x}O_3$, and is a binary solid solution of $PbZrO_3$ (orthorhombic) and $PbTiO_3$ (tetragonal perovskite). PZT has a perovskite type structure with the $Ti^{4+}$ and $Zr^{4+}$ ions occupying the B site at random.

Other lead-based ferroelectric compounds include lead niobate, $PbNb_2O_6$, which has a tungsten bronze type structure. The tungsten bronze family has a more open structure compared with the perovskites and a wide range of cation and anion substitutions are possible without loss of ferroelectricity. Lead bismuth niobate ($PbBi_2Nb_2O_9$) is another example. This material has a bismuth oxide layered type structure consisting of corner-linked perovskite-like sheets separated by $(Bi_2O_2)^{2+}$ layers. The plate like crystal structure of these compounds leads to highly anisotropic ferroelectric properties. However, the piezoelectric properties are not good because of a very low poling efficiency. Poling is a process used to induce piezoelectric behaviour in a ferroelectric ceramic by applying a direct current electric field at a high temperature that is below the Curie point of the material. On application of the external field the spontaneous polarisation within each domain of the ceramic is orientated in the direction of the applied field, leading to a net polarisation in the poling direction, but the domains in a ceramic cannot fully align along the poling axis because the orientation of the polarisation is restricted by the symmetry of the crystal structure.

There has been increased interest recently in lead-free piezoelectric/ ferroelectric materials because the most commonly used piezoelectric ceramics are lead-based and are being phased out for environmental reasons relating to the toxicity of electronic waste. Alternatives which have been investigated to replace PZT include alkali metal niobates and bismuth sodium titanates (BNT).

BNT has the general formula $(Bi_{0.5}Na_{0.5})TiO_3$ and is a perovskite-type ferroelectric material. It has a high Curie temperature ($T_c$) of 320 °C and a large remanent polarisation ($P_r$) of 38 mC/cm$^2$ at room temperature. BNT-based materials are particularly attractive candidates for use in lead-free piezoelectric/ferroelectric materials.

BNT is typically synthesized by low-cost and industrial scale solid state reaction of bismuth oxide, sodium carbonate and titanium oxide. However, high calcination temperatures are needed to react the materials. Therefore, due to the low melting points of $Bi_2O_3$ ($T_m$= 826 °C) and $Na_2CO_3$ ($T_m$ = 851 °C), high vapor pressures of the Bi and Na cations might result in the loss of A-site cations and uncontrolled non-stoichiometric compositions. The main challenge is the provision of single-phase, fine-grained, reproducible and dense ceramics of given stoichiometry to obtain improved ferroelectric properties.

In view of these problems, alternative solution based production methods have been investigated. However, many of these methods require harmful or flammable solvent systems, constraining the production of larger batches. There thus remains the need for the development of new processes for the preparation of BNT materials which are compatible with large scale production.

JUNG D S ET AL: "Fine-sized Bi0.5Na0.5TiO3 powders prepared by spray pyrolysis from polymeric precursors", JOURNAL OF CERAMIC PROCESSING RESEARCH, INTERNATIONAL ORGANIZATION FOR CERAMIC PROCESSING, SEOUL, KR, vol. 11, no. 4, 1 January 2010, pages 425-431, describes the preparation of BNT by ultrasonic spray pyrolysis.

The present inventors have found that a spray-pyrolysis technique offers a highly attractive alternative which is non-toxic, low-cost, and can viably be up-scaled to production on a ton scale. The inherent properties of the spray pyrolysis fabrication method are suitable for production of BNT ceramics. Both Na and Bi are volatile in BNT at temperatures and durations applied for other powder synthesis routes (solid state synthesis and solution based), while the short reaction time in the spray pyrolysis furnace limits the evaporation of volatile elements. Moreover, the solution based precursor employed during spray pyrolysis enables atomic scale homogeneity, rendering low temperature post-treatment sufficient for homogeneous cation distribution in the final ceramic. Lower temperature and shorter holding times during heat treatments renders the stoichiometric and homogeneous control obtained by spray pyrolysis unmatched by competing BNT production technologies.

Ceramic processing of the spray-pyrolysed BNT powders to dense BNT ceramics have confirmed that the materials fabricated from the spray pyrolysis powder possess electromechanical performance and electrical field induced strain in line with state of the art materials reported in the literature. The BNT powder is well suited for several ceramic processing techniques such as uniaxial pressing or tape casting.

The synthesis route of the present invention starts with a stable solution of cations to build up the material. To achieve a small particle size from the solution, spray pyrolysis is used to directly prepare the oxide powder. By using spray pyrolysis, a large scale preparation of high quality powder is possible. The process of the present invention can be applied to form a vast range of BNT materials.

## Summary of the invention

Thus, view from a first aspect, the invention provides a process for the preparation of a bismuth sodium titanate (BNT) compound of formula (I);

$$(Bi_{0.5-z}Na_{0.5})_{1-x}A_xTi_{1-y}B_yO_3 \qquad (I)$$

wherein

A is one or more of Bi, Na, Li, K, Mg, Ca, Sr, Ba, La, Al, Cu, Eu, Ag and Zn;
B is one or more of Ti, Nb, Ta, Zr, Fe, Nd, Eu and Co;

$$0 \leq x \leq 0.8;$$

$$0 \leq y \leq 0.8;$$

and

$$-0.1 \leq z \leq 0.1;$$

said process comprising spray pyrolysis of a solution comprising Bi ions, Na ions, Ti ions and, if present, metal (A) and/or metal (B) ions, wherein said spray pyrolysis is carried out using a dual phase nozzle arrangement.

## Detailed Description

The invention relates to a process for the preparation of a bismuth sodium titanate (BNT). **BNT**

The BNT materials prepared according to the invention are represented by the general formula (I)

$$(Bi_{0.5-z}Na_{0.5})_{1-x}A_xTi_{1-y}B_yO_3 \qquad (I)$$

wherein

A is one or more of Bi, Na, Li, K, Mg, Ca, Sr, Ba, La, Al, Cu, Eu, Ag and Zn;
B is one or more of Ti, Nb, Ta, Zr, Fe, Nd, Eu and Co;

$$0 \leq x \leq 0.8;$$

$$0 \leq y \leq 0.8;$$

and

$$-0.1 \leq z \leq 0.1.$$

General formula (I) covers both stoichiometric and non stoichiometric compounds. The cations and anions are generally present in such ratios that a stable perovskite structure is formed.

It is however preferred if the compounds are essentially stoichiometric. The description refers to stoichiometric compounds.

Each of A and B may be present as a single metal or a mixture of two or more metals. Preferably, A and B are each a single metal.

In one preferred aspect of the invention the BNT compounds of formula (I) formed by the process of the invention are not doped, i.e. the value of x = 0 and the value of y is 0. If a doping ion A or B is present, it is preferred that only one doping ion is present, i.e. if a A ion is present then y is 0 or if a B ion is present then x is 0.

It is another aspect of the invention that the compound of formula (I) can be doped such that the value of x is between 0 and a maximum of 0.5, more preferably between 0 and 0.3. It is another aspect of the invention that the compound of formula (I) can be doped such that the value of y is between 0 and a maximum of 0.5, more preferably between 0 and 0.3.

Preferred doping metal ions (A) are Bi, Na, Li, K, Ca, Sr or Ba, especially Bi, Na, Li, K or Ba, such as Ba or K.

Preferred doping metal ions (B) are Ti, Nb, Ta or Zr, especially Nb.

In one aspect of the invention metal ion A can be a metal or a mixture of two or more metals selected from Ba, Li, Na and K. Preferably the metal is Ba, Na or K, or a mixture of Ba, Na and K, and most preferably a mixture of Ba, Na and K. Where two alkali metals, e.g. Na and K are present the preferred molar ratio of each metal is in the range 0.4:0.6 to 0.6:0.4, more preferably 0.45:0.55 to 0.55:0.45, most preferably 1:1.

Particularly preferable sub-groups of formula (I) are:

$(Bi_{0.5-z}Na_{0.5})_{1-x}A_xTi_{1-y}B_yO_3$, where $A$ is one or more of Bi, Na, Li, K, Ca, Sr, Ba; $B$ is one or more of Ti, Nb, Ta, Zr; $0 \leq x \leq 0.5$; $0 \leq y \leq 0.5$; and $-0.1 \leq z \leq 0.1$; or

$(Bi_{0.5-z}Na_{0.5})_{1-x}A_xTi_{1-y}B_yO_3$, where $A$ is one or more of Bi, Na, Li, K, Ba; $B$ is one or more of Ti, Nb, Ta, Zr; $0 \leq x \leq 0.3$; $0 \leq y \leq 0.3$; and $-0.1 \leq z \leq 0.1$.

It is especially preferred if the BNT compound prepared according to the invention which is formed in the spray pyrolysis process has a very small particle size (also called crystallite size herein), e.g. a particle or crystallite size of less than 600 nm, e.g. less than 500 nm. In some especially preferred embodiment the particle or crystallite size is less than 250 nm, especially less than 100 nm, e.g. less than 60 nm. The particle sizes quoted herein represent average particle size. Particle or crystallite sizes may be measured by surface area or by electron microscopy studies.

The specific surface area of the particles of the BNT compounds is typically in the range 0.5 to 100 $m^2/g$, especially 1 to 50 $m^2/g$, such as 2-30 $m^2/g$, e.g. 3-20 $m^2/g$.

It is a preferred feature of this invention that the primary particles or crystallites formed by the spray pyrolysis process are already of a size which can be used without any milling procedure. It may however be necessary to break up soft agglomerates of particles which can form during spray pyrolysis. Whilst break up of the particles is typically achieved using a milling machine, the energy required to break up a soft agglomerate of primary particles is very much lower than the energy required to mill a primary particle.

**Process**

The process of the invention involves the spray pyrolysis of a solution containing all the metal ions required to form the desired compound of formula (I). The invention relies therefore on the formation of a solution of the metal ions necessary to form the BNT material of formula (I). It is therefore necessary to provide soluble metal salts of each reactant metal ion.

For any metal ion, any convenient metal salt can be used if it is soluble. Preferred metal salts are nitrates, alkoxides, carboxylates, ketonates, oxalates and/or dioxalates, and salts of organic acids, especially citrates and acetates. Particularly preferred are nitrates.

The solution required can be prepared by dissolving salts in the solvent simultaneously or sequentially or could involve the preparation of one or more precursor solutions containing one or more of the reactant metal ions. The skilled man can devise ways of making the solution required. Preferably the invention utilises precursor solutions of each metal ion required which are subsequently mixed before being subjected to spray pyrolysis.

Soluble metal salts can be prepared using any convenient counter ion (e.g. a nitrate, chloride, sulphate and so on) or using one or more complexing agents with appropriate solvent. Suitable complexing agents could be hexadentate, pentadentate, tetradentate, tridentate or bidentate ligands, in particular amino polycarboxylic acid chelating agents. Suitable ligands include EDTA, cyclohexanediamine tetraacetic acid (CDTA), citric acid, malic acid, maleic acid, DOTA, DTPA and ethylene diamine.

Preferably the solution is an aqueous solution, i.e. comprising water (e.g. distilled water). The skilled man will appreciate that metal salts are generally readily soluble so all manner of salts can be used here although it is essential that the counter ion/complexing agent used with the metal ion A, B, Bi and/or Ti does not form insoluble salts with any other metal ion present.

It is typical for the Bi precursor solution to further comprise a stabiliser, such as ethanolamine. Without stabilization of Bi, precipitation can occur at pH higher than 1, limiting the safety and compatibility to other cation precursors.

The molarity of the precursor solutions used in the process of the invention is preferably in the range of 0.01 to 4 M, e.g. 0.1 to 2 M. Stirring, sonication or other mixing techniques can be used to ensure homogeneity. Preferably mixing of the metal salt and water takes place over a period of at least 6 hours. It is also preferred if during this stirring process the temperature is elevated slightly, e.g. up to 80°C or higher if vessel is pressurized.

The ions of Bi, Na and Ti and optionally A and B ions can then be mixed in an appropriate ratio (e.g. depending on the molarity of each solution used and the desired stoichiometry of the final product) and the solution which forms can be spray pyrolysed. Stirring, sonication or other mixing techniques can again be used to ensure homogeneity of the solution prior to or during spray pyrolysis. Preferably mixing takes place over a period of at least 6 hours.

It is highly preferred if the solvent used throughout the manufacturing process comprises water (e.g. comprises at least 80wt%, such as at least 90 wt% water). Most preferably the solvent consists of water.

The pressure at the nozzle in the spray pyrolysis process may be in the range 1 to 3 bars. This may be achieved using a nozzle 0.5 to 5 mm, preferably 1 to 2 mm in diameter. The atomising gas can be any gas which is inert to the reactant materials, including air.

Atomisation occurs into a furnace at temperatures of at least 500 °C. Ideally, the temperature is in the range 700 to 1200°C, preferably 750 to 950°C.

In a particularly preferred embodiment, the processes of the invention do not comprise the use of ultrasound at the nozzle.

The powder which exits the furnace (e.g. at a temperature of approximately 400 to 550°C) can be collected by a cyclone or a filter.

The particles can be formed without any deposition surface We do not need to spray pyrolyse onto a surface to induce particle formation rather, our particles form due to evaporation of the solvents from the atomized droplets formed by the dual-phase nozzle described below. Deposition is in fact a potential problem as it can lead to scraping of the formed particles from the deposition surface and hence contamination. Deposition onto a surface also leads to the formation of a layer of material on that surface, i.e. to the formation of a film. The present invention primarily concerns the formation of distinguishable particles and not a thin film on a substrate. It is prefered to collect particles in a cyclone thus creating a free flowing powder and not a film.

It is therefore preferred if the particles form a free flowing powder. The formation of a free flowing powder directly after spray pyrolysis is a further preferred feature of the invention. It is thus a feature of the invention that the particles formed directly after spray pyrolysis preferably do not adhere to any surface.

In particular, it is preferred if the soft agglomerates formed at this stage of the process have a particle size distribution which conforms to D(v, 0.5) of 1 to 40 $\mu$m and a value of the ratio of D(v, 0.9)-D(v, 0.1) to D(v, 0.5) of no more than 3. Preferably, the D(v, 0.5) value is 1 to 20 $\mu$m. These values are achieved directly after spray pyrolysis and prior to subsequent processing steps.

Controlling particle size is an important aspect of the invention. In order to achieve the best control, the spray pyrolysis method of the invention employs a dual phase nozzle arrangement to ensure atomisation, narrow particle size distribution and high yields. In this arrangement, the particle precursor materials are provided in the form of an emulsion or solution which is atomised in a two phase nozzle and flows into a hot zone such as a furnace. In the hot zone each droplet is converted to a particle and any solvent/emulsion components are decomposed into gas. Particle size can be controlled by e.g. varying droplet size. Droplet size is in turn controlled by manipulation of the nozzle outlet. Langmuir 2009, 25, 3402-3406 contains a description of the use of flame spray pyrolysis in the manufacture of yttrium oxide particles and provides the skilled man with details of this known process. Other factors which could control particle size include the temperatures employed in the process and the concentration of the metal ions in the starting solution.

In particular, in the pyrolysis process, mixing means, for producing a flow mixture of solution, e.g. aqueous solution, and air, is combined with an atomizing nozzle to provide a nozzle assembly which produces a jet of very fine droplets. The nozzle assembly is used in conjunction with a hot zone such as a furnace. The mixing means comprises a pipe, external of the hot zone having separate, spaced inlets for the solution and air. A reducing diameter nozzle is positioned in the pipe bore between the inlets, for accelerating the air.

The air contacts the solution and turbulently moves down the pipe bore to produce what is known as a "bubbly flow" mixture. The mixture is fed to the nozzle, which is inside of the hot zone. The nozzle has an inlet; a first contraction section of reducing diameter for accelerating the flow, preferably to supersonic velocity, whereby the droplets are reduced in size; a diffuser section of expanding diameter wherein the mixture decelerates and a shock wave may be induced; a second contraction section operative to accelerate the mixture more than the first contraction section; and an orifice outlet for producing a jet or spray. The nozzle assembly is designed to give droplets in the region of 1 to 10 $\mu$m.

The use of a dual phase nozzle arrangement will be familiar to the skilled man.

Whilst the powder formed after the spray pyrolysis step could be used directly as a ferroelectric material, the product of the spray pyrolysis reaction normally contains minor amounts of non-combusted organic material and traces of anions from the salt that is not decomposed which can be removed by calcination (e.g. at 400 to 1200°C, preferably 550 to 1000°C, e.g. about 600 to 800°C). During calcination the powder is usually exposed to high temperature for a period of 1 to 24 hours, preferably 4 to 12 hours. It has been found that the final crystallite size can be controlled by the temperature at which calcination takes place, lower temperatures being associated with smaller crystallite sizes. During the process of the invention, the primary particles or crystallites can aggregate to form soft agglomerates. Prior to calcination these agglomerates are often of the order of less than 20 microns and hence still represent a free flowing powder. Post calcination the agglomerates have broken down into smaller aggregates of the primary particles, preferably in the range 10 to 700 nm, especially 20 to 500 nm in diameter.

The calcination step also improves the crystallinity of the formed powder. It is a preferable feature of the invention therefore that the BNT compound is a crystalline solid.

Again, the product formed after calcination and optional milling can be used directly. Viewed from another aspect the process of the invention provides a BNT obtained by the spray pyrolysis process as hereinbefore defined and after calcination.

It is also possible however for the powder formed after calcination to be milled, typically wet milled to reduce its volume. This is not essential; however, milling ensures a more consistent particle size distribution by breaking down any remaining agglomerates into the primary particles or crystallites. Any suitable type of milling method can be used, such as jet milling or ball milling. Milling can also be effected in the presence of water, ethanol, isopropanol, acetone or other solvent. Yttria-stabilized zirconia is a typical grinding medium. Milling can also be effected by impacting particles by a jet of compressed air or any inert gas.

Powders formed by this process are single phase and are typically submicron in size and non agglomerated.

Doping of the BNT materials formed by this spray pyrolysis process can be achieved readily be employing a soluble doping metal ion salt or complex in an appropriate amount. The soluble doping metal ion compound can be added into to a precursor solution of metal ions or to the mixed solution prior to spray pyrolysis in an appropriate amount depending on the amount of doping meal ion which is desired to be present. It may obviously be necessary to reduce the amount of one or more of the other precursor solution or other metal salts to reflect the amount of doping metal ion being added.

A convenient way of introducing the doping metal ions into solution is through their nitrates as these are often soluble in water. Thus, for a barium doping metal ion, a solution of barium nitrate or barium nitrate solid can be added to the mixed solution.

The process of the invention produces the BNT compound at a rate per nozzle of 0.5 to 10 kg/h, preferably 1 to 5 kg/h.

**Applications**

The BNT compounds prepared according to the invention may be employed in a range of applications where ferroelectric properties are important.

The compounds formed by the process of the invention are thus preferably ferroelectric, preferably piezoelectric. Ferroelectricity is a spontaneous electric polarization of a material that can be reversed by the application of an external electric field. Piezoelectricity is the ability to generate an electric potential in response to applied mechanical stress.

The compounds prepared according to the invention are lead free and represent environmentally acceptable alternatives to the materials used today as piezoceramics.

It is preferable that the ferroelectric composition will comprise 10-50 wt % or the BNT compound of formula (I), more preferably 15-30 wt. %, most preferably 20-25 wt.%, relative to the total weight of the composition as a whole.

In order to manufacture such ferroelectric compositions sintering of the compounds may be required. Pressing and sintering can be carried out using known conditions. For example, pressing is typically carried out at ambient temperature in any standard press. The sintering temperature is highly dependent on the composition. Normally the sintering has to be done close to the solidus temperature. Sintering can therefore occur at temperatures up to the solidus temperature of the compound, for example up to 1400°C, preferably 800 to 1250°C, especially less than 1225°C. Sintering can last 0 to 20 hrs, e.g. 2 to 12 hrs.

As noted above therefore, in order to complete the formation of desirable articles, the particles are preferably converted into a green body and then sintered. The green body can be formed by any convenient techniques such as by pressing or by casting or the like. In a highly preferred embodiment therefore, the sintering process of the invention is carried out in air.

Viewed from another aspect the invention provides a process for the preparation of a compound of formula (I) as hereinbefore defined and having a density relative to its theoretical density of at least 92%.

Hence, the inventors have surprisingly found that it is possible to produce a solid solution of bismuth sodium titanates of Formula (I) with typical particle sizes in the nanometer range. These particles are of interest as potential replacements for PZT as they are easier to sinter. The expected perovskite crystal structure should give rise to a good poling efficiency and thereby good piezoelectric properties.

The use of the compounds prepared according to the invention for manufacturing electronic and optic devices, including medical diagnostic devices such as ultrasound devices, and/or piezoelectric transformers is described.

Such devices comprising the afore-mentioned ferroelectric composition are also described. Preferred devices are in particular transducers, ultrasound diagnostic equipment, gas ignitors, accelerometers, displacement transducers, actuators, sensors and piezoelectric transformers.

In another aspect, ferroelectric composition can further comprise a polymer. The polymer should have a density lower than the ferroelectric compound. Examples are polyvinylidene fluoride, poly(vinylidene fluoride) hexafluoroproylene or epoxy polymers.

The invention will now be described further with reference to the following non-limiting examples and figures.

Brief Description of the Figures

Figure 1: X-ray diffractogram of BNT-BT material
Figure 2: SEM image of BNT-BT powder
Figure 3: SEM of sintered BNT-BT pellet
Figure 4: Strain and polarisation curves of BNT-BT material

Examples

**Test methods**

X-ray diffraction

Powder X-ray diffractograms were obtained from 20 to 70° with a Bruker D2 Phaser, equipped with a Lynxeye detector and Ni- and Cu-filters using $CuK\alpha$ radiation accelerated at 40kV and 40 mA.

SEM

Scanning electron micrographs were captured on a field emission gun SEM (Zeiss Ultra 55, Limited Edition) using the in-lens secondary electron detector.

Strain & Polarization

A piezoelectric testing system (TF Analyzer 2000, aix ACCT Systems GmbH) was used to investigate strain and polarization behaviour of the pellet samples in relation to an applied electric field. Ferroelectric hysteresis (P-E) loops were measured by linear bipolar 0.1 Hz frequency cycling.

**Example 1**

**$Bi_{0.5076}Na_{0.47}Ba_{0.06}TiO_3$ (BNT-BT) Powders Prepared by Spray Pyrolysis**

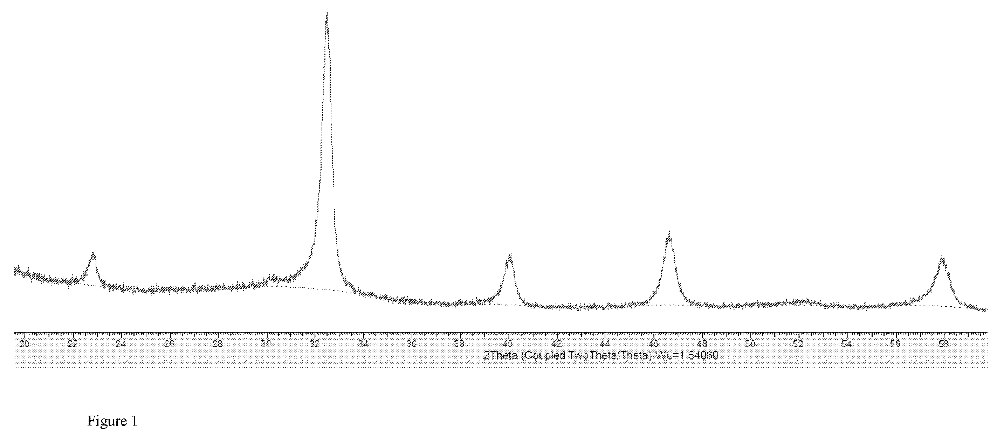

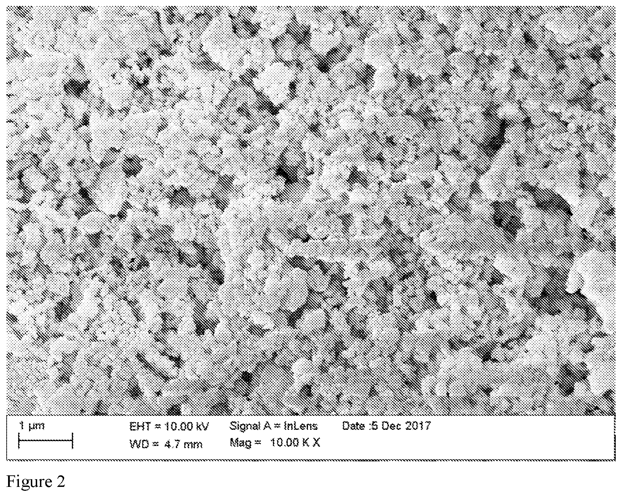

A ratio of 1:2 titanium isopropoxide, $C_{12}H_{28}O_4Ti$, and citric acid, $C_6H_8O_7$, was dissolved in distilled water in molar concentrations ~2 M to prepare the Ti-cation precursor solution. Bismuth citrate, $C_6H_5BiO_7$, and ethanolamine, $C_2H_7NO$, were mixed in a ratio 1:1.5 in distilled water in molar concentrations ~1 M. pH was increased to 7-8.5 with 25% ammonia $(NH_3)$ until suspensions begins to clear. The Bi-cation precursor solution was left stirring at room temperature overnight (12 hours). A ratio of 1:1:2 barium nitrate, $Ba(NO_3)_2$, EDTA, $C_{10}H_{16}N_2O_8$, and citric acid, $C_6H_8O_7$, was dissolved in distilled water in molar concentrations ~0.2 M. pH was increased to 6-7 with 25% ammonia $(NH_3)$ until suspensions begins to clear. The Ba-cation precursor solution was left stirring at room temperature overnight (12 hours). The concentrations of the Ti-solution and a commercial sodium hydroxide, NaOH (Alfa Aesar) were accurately measured by thermogravimetric analysis. In accordance with the concentration of the Ti and Na-solutions, appropriate amount of each solutions (Ti, Na, Bi and Ba) were sequentially added with pH adjustment with 25% ammonia $(NH_3)$ to ~7 at each step. The solution was left stirring overnight (12 hours) at room temperature and resulted in a homogeneous aqueous $Bi_{0.5076}Na_{0.47}Ba_{0.06}TiO_3$ solution which was spray pyrolyzed using a pilot scale equipment. The solution was fed into a water-cooled lance at a rate of 200 ml/min and atomised in a nozzle with aid of pressurised air. The droplets were transported through the hot zone in a furnace tube, at a set temperature of 900 °C, by an underpressurised air stream where the time of flight inside the furnace tube was less than one second. The product, called green powder, was collected in a cyclone and phase purity is documented in the x-ray diffractograms given in Figure 1. The green powder was calcined at 600 °C for 6 h to remove residues and increase crystallinity. The calcined powder was further dry milled for 30 minutes to reduce the volume and further ball milled for 24 h in 2-propanol with yttria-stabilized zirconia as grinding media. The resulting single phase powder was a submicron non-agglomerated powder as shown in the SEM micrograph of Figure 2.

### Example 2

### $Bi_{0.5}Na_{0.5}TiO_3$ (BNT) Powders Prepared by Spray Pyrolysis

The aqueous precursor solutions were prepared and mixed in stoichiometric proportions in a similar manner as for Example 1. The precursor solution was spray pyrolyzed as described under Example 1 and the resulting green powder was treated in a similar manner.

### Example 3

### The fabrication of BNT-BT pellets and sintering

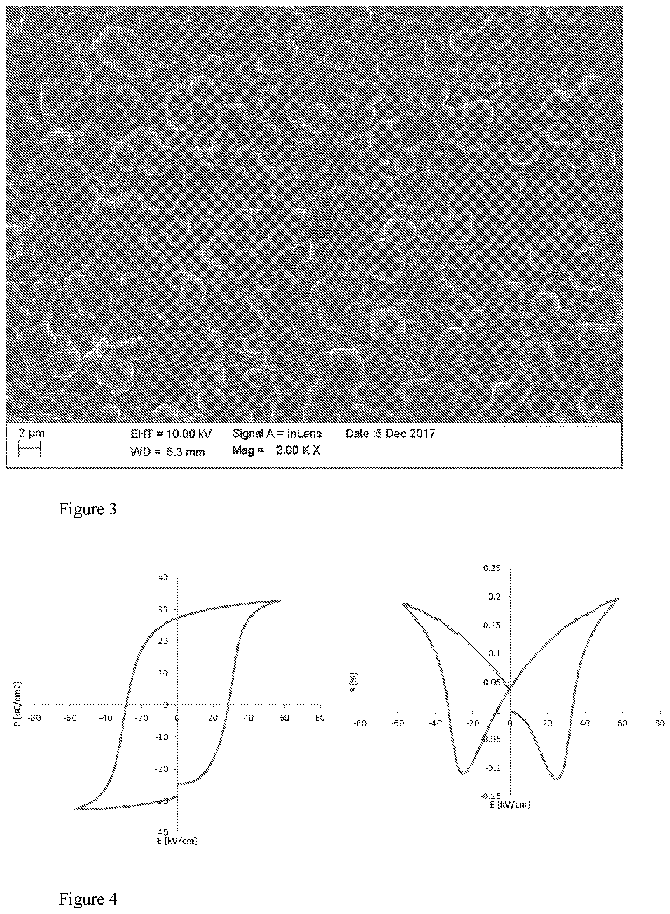

Dry powder uniaxial pressing of green bodies is the most relevant industrial preparation method for bulk ceramic materials. BNT-BT powders were pressed into cylindrical bodies of various dimensions (5 to 15 mm in diameter and 1 to 20 mm in height) using a compacting force of 75 Mpa. For all pressing experiments, double-acting stainless-steel dies were employed. The die walls were coated with an ethanol-stearic acid solution and allowed to dry, leaving stearic acid as a lubricant. The press was left for 2 minutes before releasing the force. The green bodies were finally removed from the die by employing the press to push the bottom punch steadily. The samples were sintered in air with heating rate of 200 to 400 °C/h up to temperatures in the range 950-1200 °C for 2 to 6h. Figure 3 shows the surface microstructure of a BNT-BT pellet of 5 mm in diameter sintered at 1200 °C for 2h.

### Example 4

### $Bi_{0.46}Na_{0.47}K_{0.01}Ba_{0.06}Ti_{0.98}Nb_{0.02}O_3$ or $0.92Bi_{0.5}Na_{0.5}TiO_3$-$0.06BaTiO_3$-$0.02K_{0.5}Na_{0.5}NbO_3$ (BNT-BT-KNN) Powders Prepared by Spray Pyrolysis

The aqueous precursor solutions for Ba, Na, Ti, and Bi cations were prepared and mixed stoichiometrically in a similar manner as for Example 1. The aqueous precursor solution of Nb was prepared by dissolving $C_4H_4NNbO_9*8H_2O$ in purified water and stirred overnight. The exact Nb concentration in the resulting solution was determined thermogravimetrically, and the potassium solution was prepared by dissolving stoichiometric amounts of $KNO_3$ in purified water. In accordance with the concentrations, appropriate amounts of each solution (Ti, Na, K, Nb, Bi and Ba) were sequentially added and neutralized. The solution was left stirring overnight (12 hours) at room temperature, resulting in a homogeneous aqueous $Bi_{0.46}Na_{0.5}K_{0.01}Ba_{0.06}Ti_{0.98}Nb_{0.02}O_3$ solution. The precursor solution was spray pyrolyzed as described in Example 1 and the resulting green powder was treated in a similar manner.

### Example 5

### $Bi_{0.5}Na_{0.385}K_{0.1}Li_{0.015}TiO_3$ or $0.77Bi_{0.5}Na_{0.5}TiO_3$-$0.2Bi_{0.5}K_{0.5}TiO_3$-$0.03Bi_{0.5}Li_{0.5}TiO_3$ (BNT-BKT-BLT) Powders Prepared by Spray Pyrolysis

The aqueous precursor solutions for Na, Ti, and Bi cations were prepared in a similar manner as for Example 1. K and Li precursor solutions were prepared by dissolving stoichiometric amounts of $KNO_3$ and $LiNO_3$ in purified water. In accordance with the concentrations, appropriate amounts of each solution (Ti, Na, K, Li and Bi) were sequentially added and neutralized. The solution was left stirring overnight (12 hours) at room temperature, resulting in a homogeneous aqueous $Bi_{0.5}Na_{0.385}K_{0.1}Li_{0.015}TiO_3$ solution. The precursor solution was spray pyrolyzed as described in Example 1 and the resulting green powder was treated in a similar manner.

### Example 6

**Bi$_{0.48}$Na$_{0.4032}$K$_{0.0768}$Sr$_{0.04}$TiO$_3$ or 0.96Bi$_{0.5}$(Na$_{0.84}$K$_{0.16}$)$_{0.5}$TiO$_3$-0.04SrTiO$_3$ (BNKT-ST) Powders Prepared by Spray Pyrolysis**

The aqueous precursor solutions for Bi, Na and K cations were prepared in a similar manner as for Example 5. The Sr solution precursor was made by dissolving a stoichiometric amount of Sr(NO$_3$)$_2$ anhydrate in purified water. In accordance with the concentrations, stoichiometric amounts of each solution were added in the following sequence: Ti, Na, Bi, K and Sr, and neutralized after NaOH and Bi additions. The solution was left stirring overnight (12 hours) at room temperature, resulting in a homogeneous aqueous Bi$_{0.48}$Na$_{0.4032}$K$_{0.0768}$Sr$_{0.04}$TiO$_3$ solution. The precursor solution was spray pyrolyzed as described in Example 1 and the resulting green powder was treated in a similar manner.

**Claims**

1. A process for the preparation of a bismuth sodium titanate (BNT) compound of formula (I);

$$(Bi_{0.5-z}Na_{0.5})_{1-x}A_xTi_{1-y}B_yO_3 \qquad (I)$$

wherein

A is one or more of Bi, Na, Li, K, Mg, Ca, Sr, Ba, La, Al, Cu, Eu, Ag and Zn;
B is one or more of Ti, Nb, Ta, Zr, Fe, Nd, Eu and Co;

$$0 \leq x \leq 0.8;$$

$$0 \leq y \leq 0.8;$$

and

$$-0.1 \leq z \leq 0.1;$$

said process comprising spray pyrolysis of a solution comprising Bi ions, Na ions, Ti ions and, if present, metal (A) and/or metal (B) ions, wherein said spray pyrolysis is carried out using a dual phase nozzle arrangement.

2. The process as claimed in claim 1, wherein A is one or more of Bi, Na, Li, K, Ca, Sr, Ba; B is one or more of Ti, Nb, Ta, Zr; $0 \leq x \leq 0.5$; $0 \leq y \leq 0.5$; and $-0.1 \leq z \leq 0.1$.

3. The process as claimed in claim 1 or 2, wherein A is one or more of Bi, Na, Li, K, Ba; B is one or more of Ti, Nb, Ta, Zr; $0 \leq x \leq 0.3$; $0 \leq y \leq 0.3$; and $-0.1 \leq z \leq 0.1$.

4. The process as claimed in any of claims 1 to 3, wherein A and B are each a single metal.

5. The process as claimed in any of claims 1 to 4, wherein only one of A or B is present.

6. The process according to any preceding claim wherein spray pyrolysis is performed by atomisation of the solution into a furnace at a temperature of at least 500°C.

7. The process according to any preceding claim wherein said solution is an aqueous solution.

8. The process according to any preceding claim wherein the aqueous solution is prepared from water soluble precursors comprising at least one metal citrate or metal nitrate.

9. The process according to any preceding claim in which said BNT compound forms a free flowing powder directly after spray pyrolysis.

10. The process according to any preceding claim in which said BNT compound formed directly after spray pyrolysis does not adhere to any surface.

11. The process according to any preceding claim in which the particles obtained directly after spray pyrolysis are perovskite in structure.

12. The process according to any preceding claim further comprising collecting the spray pyrolysis fine powder product by cyclone and calcining at a temperature in the range of 400-1200°C.

13. The process as claimed in claim 12 wherein said calcination is carried out at a temperature of 550 to 1000°C.

14. A process as claimed in claim 12 or 13 further comprising milling of the powder after calcination.

**Patentansprüche**

1. Verfahren zur Herstellung einer Bismut-Natrium-Titanat- (BNT)- Verbindung der Formel (I);

$$(Bi_{0,5-z}Na_{0,5})_{1-x}A_xTi_{1-y}B_yO_3 \qquad (I)$$

wobei

A eines oder mehrere von Bi, Na, Li, K, Mg, Ca, Sr, Ba, La, Al, Cu, Eu, Ag und Zn ist;
B eines oder mehrere von Ti, Nb, Ta, Zr, Fe, Nd, Eu und Co ist;

$$0 \leq x \leq 0,8;$$

$$0 \leq y \leq 0,8;$$

und

$$-0,1 \leq z \leq 0,1;$$

das Verfahren die Sprühpyrolyse einer Lösung umfasst, die Bi-Ionen, Na-Ionen, Ti-Ionen und, falls vorhanden, Metall (A)- und/oder Metall (B)-Ionen umfasst, wobei die Sprühpyrolyse unter Verwendung einer Zweiphasendüsenanordnung durchgeführt wird.

2. Verfahren nach Anspruch 1, wobei A eines oder mehrere von Bi, Na, Li, K, Ca, Sr, Ba ist; B eines oder mehrere von Ti, Nb, Ta, Zr ist; $0 \leq x \leq 0,5$; $0 \leq y \leq 0,5$; und $-0,1 \leq z \leq 0,1$ ist.

3. Verfahren nach Anspruch 1 oder 2, wobei A eines oder mehrere von Bi, Na, Li, K, Ba ist; B eines oder mehrere von Ti, Nb, Ta, Zr ist; $0 \leq x \leq 0,3$; $0 \leq y \leq 0,3$; und $-0,1 \leq z \leq 0,1$ ist.

4. Verfahren nach einem der Ansprüche 1 bis 3, wobei A und B jeweils ein einziges Metall sind.

5. Verfahren nach einem der Ansprüche 1 bis 4, wobei nur eines von A oder B vorhanden ist.

6. Verfahren nach einem vorstehenden Anspruch, wobei die Sprühpyrolyse durch Zerstäubung der Lösung in einem Ofen bei einer Temperatur von mindestens 500 °C durchgeführt wird.

7. Verfahren nach einem vorstehenden Anspruch, wobei die Lösung eine wässrige Lösung ist.

8. Verfahren nach einem vorstehenden Anspruch, wobei die wässrige Lösung aus wasserlöslichen Vorläufern hergestellt wird, die mindestens ein Metallcitrat oder ein Metallnitrat umfassen.

9. Verfahren nach einem vorstehenden Anspruch, wobei die BNT-Verbindung unmittelbar nach der Sprühpyrolyse ein rieselfähiges Pulver bildet.

10. Verfahren nach einem vorstehenden Anspruch, wobei die BNT-Verbindung, die unmittelbar nach der Sprühpyrolyse gebildete wird, nicht an einer beliebigen Oberfläche haftet.

**11.** Verfahren nach einem vorstehenden Anspruch, wobei die Partikel, die unmittelbar nach der Sprühpyrolyse erhaltenen werden, eine Perowskitstruktur aufweisen.

**12.** Verfahren nach einem vorstehenden Anspruch, weiter umfassend ein Sammeln des feinen Sprühpyrolyse-Pulverprodukts durch einen Zyklon und ein Kalzinieren bei einer Temperatur im Bereich von 400-1200 °C.

**13.** Verfahren nach Anspruch 12, wobei die Kalzinierung bei einer Temperatur von 550 bis 1000 °C durchgeführt wird.

**14.** Verfahren nach Anspruch 12 oder 13, weiter umfassend ein Mahlen des Pulvers nach der Kalzinierung.

**Revendications**

**1.** Procédé de préparation d'un composé de titanate de sodium de bismuth (BNT) de formule (I) ;

$$(Bi_{0,5-z}Na_{0,5})_{1-x}A_xTi_{1-y}B_yO_3 \qquad (I)$$

dans lequel

A est un ou plusieurs parmi Bi, Na, Li, K, Mg, Ca, Sr, Ba, La, Al, Cu, Eu, Ag et Zn ;
B est un ou plusieurs parmi Ti, Nb, Ta, Zr, Fe, Nd, Eu et Co ;

$$0 \leq x \leq 0,8 ;$$

$$0 \leq y \leq 0,8 ;$$

et

$$-0,1 \leq z \leq 0,1 ;$$

ledit procédé comprenant une spray-pyrolyse d'une solution comprenant des ions Bi, des ions Na, des ions Ti et, s'ils sont présents, des ions métalliques (A) et/ou métalliques (B), dans lequel ladite pyrolyse par pulvérisation est réalisée à l'aide d'un agencement de buses biphasique.

**2.** Procédé tel que revendiqué dans la revendication 1, dans lequel A est un ou plusieurs parmi Bi, Na, Li, K, Ca, Sr, Ba ; B est un ou plusieurs parmi Ti, Nb, Ta, Zr ; $0 \leq x \leq 0,5$ ; $0 \leq y \leq 0,5$ ; et $-0,1 \leq z \leq 0,1$.

**3.** Procédé tel que revendiqué dans la revendication 1 ou la revendication 2, dans lequel A est un ou plusieurs parmi Bi, Na, Li, K, Ba ; B est un ou plusieurs parmi Ti, Nb, Ta, Zr ; $0 \leq x \leq 0,3$ ; $0 \leq y \leq 0,3$ ; et $-0,1 \leq z \leq 0,1$.

**4.** Procédé tel que revendiqué dans l'une quelconque des revendications 1 à 3, dans lequel A et B sont chacun monométallique.

**5.** Procédé tel que revendiqué dans l'une quelconque des revendications 1 à 4, dans lequel seul l'un parmi A ou B est présent.

**6.** Procédé selon une quelconque revendication précédente dans lequel la spray-pyrolyse est réalisée par atomisation de la solution dans un four à une température d'au moins 500 °C.

**7.** Procédé selon une quelconque revendication précédente dans lequel ladite solution est une solution aqueuse.

**8.** Procédé selon une quelconque revendication précédente dans lequel la solution aqueuse est préparée à partir de précurseurs solubles dans l'eau comprenant au moins un citrate métallique ou un nitrate métallique.

**9.** Procédé selon l'une quelconque des revendications précédentes dans lequel ledit composé BNT forme une poudre fluide directement après la spray-pyrolyse.

10. Procédé selon l'une quelconque des revendications précédentes dans lequel ledit composé BNT formé directement après la spray-pyrolyse n'adhère à aucune surface.

11. Procédé selon l'une quelconque des revendications précédentes dans lequel les particules obtenues directement après la spray-pyrolyse sont de la pérovskite dans la structure.

12. Procédé selon une quelconque revendication précédente comprenant en outre la collecte du produit en poudre fine de spray-pyrolyse par cyclone et la calcination à une température dans la plage de 400 à 1200 °C.

13. Procédé tel que revendiqué dans la revendication 12, dans lequel ladite calcination est effectuée à une température de 550 à 1000 °C.

14. Procédé tel que revendiqué dans la revendication 12 ou la revendication 13 comprenant en outre le broyage de la poudre après calcination.

Figure 1

| 1 µm | EHT = 10.00 kV | Signal A = InLens | Date :5 Dec 2017 |
| | WD = 4.7 mm | Mag = 10.00 K X | |

Figure 2

Figure 3

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JUNG D S et al.** Fine-sized Bi0.5Na0.5TiO3 powders prepared by spray pyrolysis from polymeric precursors. *JOURNAL OF CERAMIC PROCESSING RESEARCH, INTERNATIONAL ORGANIZATION FOR CERAMIC PROCESSING, SEOUL, KR*, 01 January 2010, vol. 11 (4), 425-431

- *Langmuir*, 2009, vol. 25, 3402-3406